# EUROPEAN PATENT APPLICATION

(11) **EP 3 745 592 A1**
(43) Date of publication of application: **02.12.2020**
(21) Application number: 19908079.7
(22) Date of filing: 26.11.2019
(51) Int. Cl.: H03K 17/041

(54) **DESIGN FOR INCREASING SWITCHING SPEED OF POWER ELECTRONIC SWITCHING DEVICE, AND APPLICATION**

(30) Priority: 29.03.2019 CN 201910259042
(71) Applicant: LYU, Jianhua, Jiangsu 215000 (CN)
(72) Inventor: LYU, Xinghua, Suzhou Jiangsu 215000 (CN); LYU, Jianhua, Jiangsu 215000 (CN)
(74) Representative: Cabinet Chaillot
(86) International application number: PCT/CN2019/120821
(87) International publication number: WO 2020/199615

(57) **Abstract**

The present disclosure provides an application and design for improving a switch speed of a power electronic switch device, wherein the switch chip is provided with an auxiliary pseudo-saturation voltage functional circuit such that the switch chip is switchable to different predetermined saturated voltage states when the switch chip is saturated, and smear time constant of a base region is reduced and total smear power consumption of in an off period is reduced, whereupon a design limit of the switch speed is improved. The technical solutions according to the present disclosure greatly improve the switch speed of the switch device, and further significantly enhance the usage reliability of the switch device. In this way, the design is furthered and detailed. Researches and developments of small devices such as energy-saving lamps, electric fans, microwave ovens, air conditioners and instant water heater employing switch power controlled heating, and large equipment such as electric power dragging devices of high-speed railways, laser guns, electromagnetic cannons, and even aerospace dynamics all require a large amount of energy conversion. In this case, core switch devices in the power electronic industry are inevitably used.

## Description

### TECHNICAL FIELD

The present disclosure relates to power electronic switch devices, and in particular, relates to a design and application for improving a switch speed of a power electronic switch device.

### BACKGROUND

Device manufacturing in the electronics industry in the ever constant developments may be divided into two categories from the perspective of use. One is the relatively traditional, mature, widely used, and rapidly developing weak power industry, and the other is the power electronic power elements and devices used in the strong power industry. Developments of the power electronic power elements and devices may be roughly categorized into several stages including ordinary transistors, thyristors, large transistor composite modules GTR and IGBT. One of the performance signs reflecting the developments of such power electronic power elements and devices is that the switch speed is gradually improved with the emergence of new devices.

However, because the switch speeds of various devices are all subject to their typical upper limit, the speed-up of switch-on or switch-off of such power electronic power elements and devices has become challenging in application of the switch devices and has risen to the forefront development. The reason why the switch speed is limited is well known to technicians in the industry, that is, the final stage of such power electronic power elements and devices is usually served by bipolar transistors. According to the operating principles of the bipolar transistor, the condition for normal conduction operation of the bipolar transistor is that it is necessary to inject carriers with the same polarity as the base region into the base region without carriers, such that the base region is in a conductive state similar to a metal structure. In the smearing process after the driving pulse is turned off, although the driving pulse is turned off, no new carriers are injected into the base region, but the carriers that have been injected into the base region for conduction may not disappear immediately. As such, the conduction current that constitutes what is called a smear current is still present. Moreover, the greater the operating current when the switch device is in a saturated conduction operating state, the more carriers need to enter the base region. As such, the smear current generated each time the switch device is turned off is greater. Since the power consumption of the smear time constant t0 segment of the device at each turn-off needs to reach the magnitude of output power (the extreme value is 1/4 of the output power value) and far exceed the rated power consumption of the switch device, if the range of the switch cycle is defined to be small but far from being substantially equivalent to the smear time constant t0, an increase amount of the total average power consumption of the switch device may far exceeds the limit sustainable by the device and fails to operate normally even if the cycle is only shortened a little bit.

In other words, due to the above-mentioned reason that the turn-off power is particularly large, the switch cycle of the switch device has a special variable value and is limited not to be too short. In this way, the average power consumption of the device may be suppressed only by prolonging the switch cycle. To be specific, during design by using such elements and devices, the switch frequency needs to be defined by the switch frequency of the type of the switch device employed, and may not defined to be too high.

It can also be seen from the above analysis that even if the switch speed of the component is limited, the power consumption impact of the smear time constant t0 segment each time the component is turned off still exceeds the limit that the component is sustainable. As such, the reliability of the elements and devices is implicitly reduced, and normal life time of components is shortened.

### SUMMARY

The present disclosure is intended to provide a method for improving a switch speed of a power electronic switch chip, and to reduce damages caused by smear currents to devices to improve reliability of the devices.

The specific concept is to greatly shorten a smear time constant t0 of a base region of a bipolar power transistor. Under such concept and object, results of the experiments carried are powerful. The results are particularly awesome in the experiments or tests for testing a switch speed of a GTR module. The improved thyristor design with eight layers of P and N spaced according to this concept may not only be easily turned off, but also the switching speed is expected to reach the level of the existing IGBT module.

The present disclosure employs the following technical solutions:
For improvement of the switch speed of the switch device and reduction of the damages caused by the smear current to the device to improve the reliability of the device, the pseudo-saturation voltage Ucer_{pseudo} of the switch device under specific conditions, and the pseudo-saturation voltage Ucer_{pseudo} is set to be in a medium to low range of from several volts to 30 to 50 volts for the expectation of great reductions of the smear time constant of the base region and the total smear power consumption in the off period. In this way, the designed limit of the switch speed may be improved.

In some switch circuits with a long conduction time, although the average power consumption of the switch device does not exceed the rated value thereof, to reduce the implicit reduction of the reliability and impacts cause to the normal life time of the device by the power consumption impact in the t0 segment, the design concept is a better choice. However, this design concept is to improve the overall performance of full cycle switch-on or switch-off of the circuit by increasing the power consumption of the switch device in the conduction time period. Therefore, in most of the time period when the switch is turned on, it is not necessary to increase the power consumption over the power consumption in the conventionally designed low-voltage saturation state. This may reduce the power consumption as much as possible by driving the circuit to switch the value of the pseudo-saturation voltage such that the device is in a conventional low saturation voltage state in most of the conduction time period (the low saturation voltage state is also a prominent advantage when a GTR device is used). A short conduction time period before switch-off is sufficient to cause the driving circuit to switch to another high-voltage pseudo-saturation state to reduce the value of t0 for the expectation that the switch speed is improved during switch-off.

The technical feature of the circuit structure of this design is that a (regulatable) voltage stabilizer assembly is additionally provided, and considering the requirement that an average power consumption of the saturation conduction and off-smear within the entire switch cycle of the device is minimized, several pseudo-saturation voltages Ucer_{pseudo}.are defined in accordance with different use requirements by adjusting the specific value of the voltage stabilization, and then finally determine a combination of the voltage stabilizer devices to obtain an optimal switch speed. The other circuit structures may be integrated on the chip of a power module as a constitutional part of the chip, or may be independently designed as a separate element, which serves as a module configured in the chip.

The present disclosure achieves the following beneficial effects:
The technical solutions according to the present disclosure greatly improve the switch speed of the switch device, and further significantly enhance the usage reliability of the switch device. In this way, the design is furthered and detailed. Researches and developments of small devices such as energy-saving lamps, electric fans, microwave ovens, air conditioners and instant water heater employing switch power controlled heating, and large equipment such as electric power dragging devices of high-speed railways, laser guns, electromagnetic cannons, and even aerospace dynamics all require a large amount of energy conversion. In this case, core switch devices in the power electronic industry are inevitably used.

### BRIEF DESCRIPTION OF THE DRAWINGS

The present disclosure is further described with reference to the accompanying drawings and exemplary embodiments.
FIG. 1 is a principle diagram of a partially improved circuit for improving a switch speed of a thyristor module according to an embodiment of the present disclosure;
FIG. 2 is a principle diagram of a partially improved circuit for improving a switch speed of an IGBT module according to an embodiment of the present disclosure;
FIG. 3 is a principle diagram of a partially improved circuit for improving a switch speed of a GTR module according to an embodiment of the present disclosure;
FIG. 4 is a principle diagram of a pseudo-saturation clamp circuit of an auxiliary pseudo-saturation voltage independent module according to an embodiment of the present disclosure;
FIG. 5 is a schematic improved structural diagram of a primary chip of a thyristor module according to an embodiment of the present disclosure; and
FIG. 6 is a schematic improved structural diagram of a primary chip of an IGBT module according to an embodiment of the present disclosure.

### DETAILED DESCRIPTION

The present disclosure provides a method for improving a switch speed of a power electronic switch chip. The switch chip is provided with an functional circuit structure such that the switch chip is switchable to different predetermined saturated voltage states when the switch chip is saturated, and smear time constant of a base region is reduced and total smear power consumption of in an off period is reduced, whereupon a design limit of the switch speed is improved. Application of the method according to the present disclosure is described with reference to the specific embodiments.

### Embodiment 1

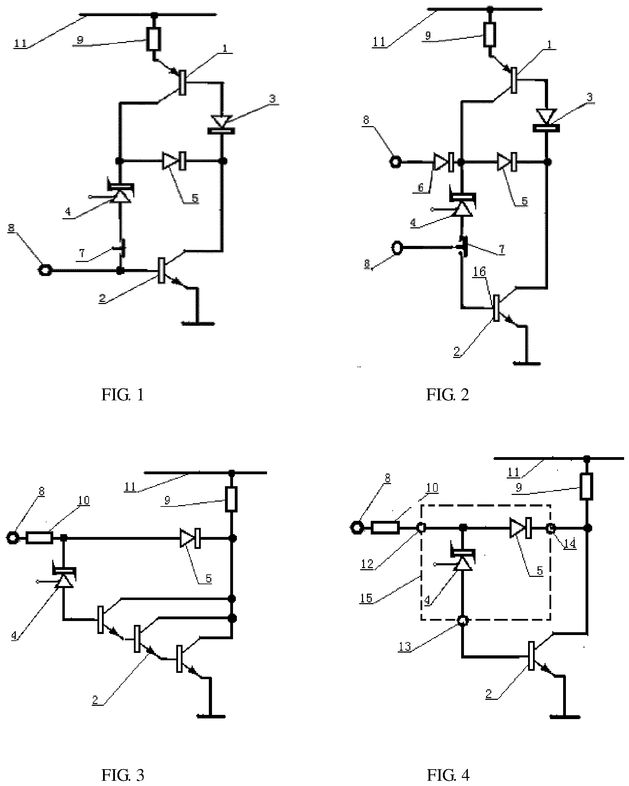

As illustrated in FIG. 1, a principle diagram of a partially improved circuit for improving a switch speed of a thyristor module according to an embodiment of the present disclosure is given. In FIG. 1, a PNP-type power transistor 1, an NPN-type power transistor 2, a diode 3, a pseudo-saturation voltage Ucer_{pseudo} stabilizer assembly 4, a clamp diode 5, a switch-off electronic switch 7, a switch control pulse input 8, a load resistor Rf 9, and a supply voltage 11 are included. A sufficiently powerful conduction pulse with a pulse width defined in accordance with circuit requirements is input via the switch control pulse input 8, and under an cooperative effect achieved by selecting a minimum voltage stabilization value for the voltage stabilizer assembly 4 (or a short-circuit electronic switch is additionally connected in parallel), the thyristor is triggered to enter a conventional low-voltage deep-saturation low-power consumption conduction state. A trailing edge of the conduction pulse ends, no control current is input to the switch control pulse input 8, and the thyristor maintains the conduction process. Before entry into a quick switch-off time period, the voltage stabilizer assembly 4 is first switched to a higher pseudo-saturation voltage Ucer_{pseudo}, and a collector voltage of the NPN-type power transistor 2 rises up to a predefined high-saturation voltage Ucer_{pseudo}, such that a smear time constant of a base region of the thyristor is reduced. The smear times before and after this time period are added to the width of the conduction pulse to obtain a conduction time of the thyristor. Afterwards, the thyristor enters a state where switch-off may be accelerated after having previously entered a pseudo-saturation state with a low time constant and a high voltage (when the current of the voltage stabilizer assembly 4 is the maximum). When the thyristor needs to be switched off, the thyristor may be quickly switched off by turning off the switch-off electronic switch 7 or reversing a primary operating voltage input to the thyristor.

### Embodiment 2

As illustrated in FIG. 3, a principle diagram of a partially improved circuit for improving a switch speed of an IGBT module according to an embodiment of the present disclosure is given. In FIG. 3, a PNP-type power transistor 1, an NPN-type power transistor 2, a diode 3, a pseudo-saturation voltage Ucer_{pseudo} stabilizer assembly 4, a clamp diode 5, a field-effect electronic switch 7, a switch control pulse input 8, a load resistor Rf 9, a supply voltage 11, and a drive trigger base 16 of a power transistor of the IGBT module are included. The PNP-type power transistor 1 and the NPN-type power transistor 2 of the IGBT module at a final stage are connected in series by the diode2, the drive trigger control bases 16 of the power transistors of the IGBT module are each connected in series to the regulatable or predefined pseudo-saturation voltage Ucer_{pseudo} stabilizer assembly 4 and then connected to a collector of the PNP-type power transistor 1 originally corresponding thereto, the drive trigger control bases 16 of the power transistors of the IGBT module are further connected in series to the field-effect electronic switch controlled by an input conduction drive, the base of the PNP-type power transistor of the power transistors of the IGBT module is connected to a collector of the NPN-type power transistor 2 by the diode 3, and the field-effect drive output 8 of the IGBT module at a front stage is connected to a trigger base of the power transistor by a conducted drive input diode 6. The operating process for improving the switch speed of the IGBT module is similar to that of the thyristor according to Embodiment 1, which is thus not described herein any further.

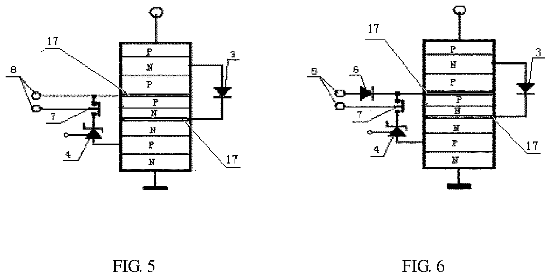

FIG. 5 and FIG. 6 are schematic improved structural diagrams of a primary chip of a thyristor module and a primary chip of an IGBT module, wherein reference numeral 17 denotes a metal conductive layer.

### Embodiment 3

As illustrated in FIG. 3, a principle diagram of a partially improved circuit for improving a switch speed of a GTR module according to an embodiment of the present disclosure is given. In FIG. 3, a power Darlington transistor 2, a pseudo-saturation voltage Ucer_{pseudo} stabilizer assembly 4, a clamp diode 5, a load resistor Rf 9, a drive pulse current limit resistor Ri 10, and a supply voltage 11. The Darlington transistor, due to the cascaded amplification function thereof, causes a severe smear phenomenon. The results of the experiments or tests using the structure according to the present disclosure reveal that when the selected pseudo-saturation voltage Ucer_{pseudo} is about ten voltages, a stable operating frequency of a switch power supply designed by using the GTR module having the Darlington structure as the switch device is greatly improved from a typical limit less than 5 KHz to tens of thousands of Hz.

### Embodiment 4

As illustrated in FIG. 4, the present disclosure further provides an auxiliary pseudo-saturation voltage independent module. In FIG. 4, a power transistor 2, a pseudo-saturation voltage Ucer_{pseudo} stabilizer assembly 4, a pseudo-saturation clamp high-speed diode 5, a load resistor Rf 9, a drive pulse current limit resistor Ri 10, a supply voltage 11, an drive pulse input 12 of the auxiliary pseudo-saturation independent module, a drive pulse output 13 of the auxiliary pseudo-saturation independent module, and a clamp end 14 of the auxiliary pseudo-saturation independent module. The dotted line block denotes an auxiliary pseudo-saturation voltage independent module 15. The auxiliary pseudo-saturation voltage independent module 15 defines an auxiliary pseudo-saturation voltage functional circuit element as an independent module. The element includes the regulatable or predefined pseudo-saturation voltage stabilizer assembly 4 and the collector pseudo-saturation voltage clamp high-speed diode 5. An anode of the pseudo-saturation voltage stabilizer assembly 4 is connected to a base of the power transistor 2, and a cathode of the pseudo-saturation voltage stabilizer assembly 4 is connected to an anode of the clamp high-speed diode 5. A cathode of the clamp high-speed diode 5 is connected to a collector of the power transistor 2. The auxiliary pseudo-saturation voltage independent module has a wide applicability, and there is no need to re-design the original power chip.

The above embodiments are merely given for illustration of the technical concepts and characteristics of the present disclosure, and are intended to better help persons skilled in the art to understand the content of the present disclosure and practice the technical solutions according to the present disclosure. However, these embodiments are not intended to limit the protection scope of the present disclosure. Any modifications derived without departing from the spirit and essence of the main technical solutions according to the present disclosure shall be considered as falling within the protection scope of the present disclosure.

## Claims

1. A method for improving a switch speed of a power electronic switch chip, wherein the switch chip is provided with an auxiliary pseudo-saturation voltage functional circuit such that the switch chip is switchable to different predetermined saturated voltage states when the switch chip is saturated, and smear time constant of a base region is reduced and total smear power consumption of in an off period is reduced, whereupon a design limit of the switch speed is improved.

2. An auxiliary pseudo-saturation voltage independent module configured to improve a switch speed of a power electronic switch chip, wherein the auxiliary pseudo-saturation voltage independent module is configured to define an auxiliary pseudo-saturation voltage functional circuit element as an independent module, the element comprising a regulatable or predefined pseudo-saturation voltage stabilizer assembly and a collector pseudo-saturation voltage clamp high-speed diode, an anode of the pseudo-saturation voltage stabilizer assembly being connected to a base of the switch chip, a cathode of the pseudo-saturation voltage stabilizer assembly being connected to an anode of the clamp high-speed diode, a cathode of the clamp high-speed diode being connected to a collector of the switch chip.

3. An application for improving a switch speed of a power electronic switch chip, applicable to improving a switch speed of a thyristor module, wherein a PNP-type power transistor and an NPN-type power transistor of the thyristor module are connected in series by a diode, trigger control bases of the PNP-type power transistor and the NPN-type power transistor of the thyristor module are each connected in series to an anode of a pseudo-saturation voltage stabilizer assembly, a cathode of the pseudo-saturation voltage stabilizer assembly is connected to a collector of another power transistor originally corresponding thereto, and a non-drive trigger base of the PNP-type power transistor and the NPN-type power transistor is connected in series to a collector of a corresponding power transistor.

4. An application for improving a switch speed of a power electronic switch chip, applicable to improving a switch speed of an IGBT module, wherein a PNP-type power transistor and an NPN-type power transistor of the IGBT module at a final stage are connected in series by a diode, drive trigger control bases of the PNP-type power transistor and the NPN-type power transistor of the IGBT module are each connected in series to a regulatable or predefined voltage stabilizer and then connected to a collector of a power transistor originally corresponding thereto, the drive trigger control bases of the PNP-type power transistor and the NPN-type power transistor of the IGBT module are further connected in series to a field-effect electronic switch controlled by an input conduction drive, non-drive trigger bases of the PNP-type power transistor and the NPN-type power transistor of the IGBT module, and the diode are each connected in series to a collector of a corresponding power transistor, and a field-effect drive output of the IGBT module at a front stage is connected to a trigger base of the power transistor by a conducted drive input diode.

5. An application for improving a switch speed of a power electronic switch chip, applicable to improving a switch speed of a GTR module, wherein a drive base of the GTR module is connected in series to a regulatable or predefined voltage stabilizer assembly and then connected to a switch control pulse input, and an output collector of the GTR module is connected in series to a clamp high-speed diode and then connected to the switch control pulse input.
